# EUROPEAN PATENT APPLICATION

(11) **EP 4 510 376 A1**
(43) Date of publication of application: **19.02.2025**
(21) Application number: 24801071.2
(22) Date of filing: 07.05.2024
(51) Int. Cl.: H01M 50/609, H01M 50/636, H01M 10/058, H01M 10/052, G01R 31/385

(54) **BATTERY PRODUCTION CONTROL METHOD AND APPARATUS, ELECTRONIC DEVICE, AND STORAGE MEDIUM**

(30) Priority: 30.05.2023 CN 202310628398
(71) Applicant: Wuxi Lead Intelligent Equipment Co., Ltd., Wuxi, Jiangsu 214028 (CN)
(72) Inventor: CAO, XinYu, Wuxi, Jiangsu 214028 (CN); LIU, BaoLe, Wuxi, Jiangsu 214028 (CN)
(74) Representative: Rau, Schneck & Hübner Patentanwälte Rechtsanwälte PartGmbB
(86) International application number: PCT/CN2024/091510
(87) International publication number: WO 2024/244919

(57) **Abstract**

Embodiments of the present disclosure provide a method and a device for battery production, and an electronic device and a storage medium, the method may include: acquiring monitoring data corresponding respectively to a plurality of batteries in a target time period in a battery production process; determining prediction data corresponding to the next battery, based on the monitoring data corresponding respectively to the plurality of batteries; comparing the prediction data with threshold data corresponding to the battery production process to obtain a comparison result; and determining a battery production status corresponding to the battery production process based on the comparison result.

## Description

### CROSS-REFERENCE TO RELATED APPLICATIONS

The present disclosure claims priority to Chinese Patent Application No. 202310628398.2 filed with the CNIPA on May 30, 2023, entitled "METHOD AND APPARATUS FOR BATTERY PRODUCTION CONTROL, AND ELECTRONIC DEVICE AND STORAGE MEDIUM", which is hereby incorporated by reference in its entirety.

### TECHNICAL FIELD

The present disclosure **relates** to **the technical** field of automation, particularly to a method and an apparatus for battery production control, and an electronic device, and a storage medium.

### BACKGROUND

In various battery production processes, the electrolyte injection station is used for the battery electrolyte injection process of the batteries, and the riveting station is used for the battery riveting process of the batteries. Each battery production process is completed in a relatively short period of time. In actual production, it is usually manually checked whether the battery production status is abnormal, but there is a possibility of misjudgment, which reduces the stability of battery production and also reduces the qualification rate and production efficiency of the batteries.

### SUMMARY

The present disclosure provides a method and an apparatus for battery production control, an electronic device, and a storage medium, which can accurately and timely detect the battery production status, thereby improving the stability of battery production and enhancing the qualification rate and production efficiency of the batteries.

According to a first aspect of the present disclosure, a method for controlling battery production is provided, including:
acquiring monitoring data corresponding respectively to a plurality of batteries in a target time period in a battery production process; wherein the battery production process includes at least one type, and the monitoring data is used for reflecting condition of the battery after completion of the battery production process;
determining prediction data corresponding to the next battery based on the monitoring data corresponding respectively to the plurality of batteries;
comparing the prediction data with threshold data corresponding to the battery production process to obtain a comparison result; and
determining the battery production status corresponding to the battery production process based on the comparison result;
wherein, when the battery production process is a battery electrolyte injection process, the monitoring data is an amount of battery electrolyte injection, and when the battery production process is a battery riveting process, the monitoring data is a height of the rivet, the battery riveting process referring to the process of pressing the rivet into the electrolyte injection port of the battery.

Optionally, the battery production status includes a normal status, an abnormal status, and a corrected status. The abnormal status is a status where the battery production status cannot return to the normal status after the production parameters corresponding to the battery production process are adjusted. The corrected status is a status where the battery production status returns to the normal status after the production parameters corresponding to the battery production process are adjusted.

Optionally, the threshold data includes a first threshold range corresponding to the normal status and a second threshold range corresponding to the corrected status. The second threshold range includes the first threshold range. Determining the battery production status corresponding to the battery production process based on the comparison result includes:
if the comparison result indicates that the prediction data is within the first threshold range, determining that the battery production status corresponding to the battery production process is the normal status;
if the comparison result indicates that the prediction data is within the second threshold range and not within the first threshold range, determining that the battery production status corresponding to the battery production process is the corrected status; and
if the comparison result indicates that the prediction data is not within the second threshold range, determining that the battery production status corresponding to the battery production process is the abnormal status.

Optionally, after determining the battery production status corresponding to the battery production process based on the comparison result, the method further includes:
if the battery production status corresponding to the battery production process is the abnormal status, determining an abnormity range corresponding to the prediction data, and determining an abnormity level of the abnormal status based on the abnormity range; and
generating abnormity warning information corresponding to the abnormity level based on the abnormity level and the prediction data.

Optionally, after determining the battery production status corresponding to the battery production process based on the comparison result, the method further includes:
if the battery production status corresponding to the battery production process is the corrected status, determining a correspondence between the monitoring data and the production parameters based on the monitoring data corresponding respectively to the plurality of batteries and the production parameters; and
adjusting the production parameters corresponding to the next battery based on the correspondence, so that monitoring data corresponding to the next battery matches the target data corresponding to the battery production process.

Optionally, when the battery production process is the battery electrolyte injection process, the production parameter is a pre-set electrolyte injection amount corresponding to the battery electrolyte injection process, and the target data is a target electrolyte injection amount corresponding to the battery electrolyte injection process; and
when the battery production process is the battery riveting process, the production parameter is a riveting pressure value corresponding to the battery riveting process, and the target data is a target rivet height corresponding to the battery riveting process.

Optionally, determining the prediction data corresponding to the next battery based on the monitoring data corresponding respectively to the plurality of batteries includes:
feature extraction of the monitoring data corresponding respectively to the plurality of batteries to obtain data characteristics corresponding to the monitoring data, the data characteristics comprising one or more of data distribution characteristics, data dispersion characteristics, and data temporal change characteristics; and
feature analysis and prediction of the data characteristics corresponding to the monitoring data based on a data prediction model to obtain prediction data corresponding to the next battery.

According to a second aspect of the present disclosure, an apparatus for battery production control is provided, including:
a data acquisition module for acquiring monitoring data corresponding respectively to a plurality of batteries in a target time period in a battery production process, wherein the battery production process includes at least one type, and the monitoring data is used for reflecting condition of the battery after completion of the battery production process;
a data prediction module for determining prediction data corresponding to the next battery based on the monitoring data corresponding respectively to the plurality of batteries;
a data comparison module for comparing the prediction data with threshold data corresponding to the battery production process to obtain a comparison result; and
a status determination module for determining the battery production status corresponding to the battery production process based on the comparison result;
wherein, when the battery production process is a battery electrolyte injection process, the monitoring data is an amount of battery electrolyte injection, and when the battery production process is a battery riveting process, the monitoring data is a height of the rivet, the battery riveting process referring to a process of pressing the rivet into the electrolyte injection port of the battery.

Optionally, the battery production status includes a normal status, an abnormal status, and a corrected status. The abnormal status is a status where the battery production status cannot return to the normal status after the production parameters corresponding to the battery production process are adjusted. The corrected status is a status where the battery production status returns to the normal status after the production parameters corresponding to the battery production process are adjusted.

Optionally, the threshold data includes a first threshold range corresponding to the normal status and a second threshold range corresponding to the corrected status. The second threshold range includes the first threshold range. The status determination module is also used for:
if the comparison result indicates that the prediction data is within the first threshold range, determining that the battery production status corresponding to the battery production process is the normal status;
if the comparison result indicates that the prediction data is within the second threshold range and not within the first threshold range, determining that the battery production status corresponding to the battery production process is the corrected status; and
if the comparison result indicates that the prediction data is not within the second threshold range, determining that the battery production status corresponding to the battery production process is the abnormal status.

Optionally, the apparatus for battery production control may further include an exception handling module, which is configured for:
if the battery production status corresponding to the battery production process is the abnormal status, determining an abnormity range corresponding to the prediction data, and determining an abnormity level of the abnormal status based on the abnormity range; and
generating abnormity warning information corresponding to the abnormity level based on the abnormity level and the prediction data.

Optionally, the apparatus for battery production control may further include a parameter correction module, which is configured for:
if the battery production status corresponding to the battery production process is the corrected status, determining a correspondence between the monitoring data and the production parameters based on the monitoring data corresponding respectively to the plurality of batteries and the production parameters; and
adjusting the production parameters corresponding to the next battery based on the correspondence, so that monitoring data corresponding to the next battery matches the target data corresponding to the battery production process.

Optionally, when the battery production process is the battery electrolyte injection process, the production parameter is a pre-set electrolyte injection amount corresponding to the battery electrolyte injection process, and the target data is a target electrolyte injection amount corresponding to the battery electrolyte injection process; and
when the battery production process is the battery riveting process, the production parameter is a riveting pressure value corresponding to the battery riveting process, and the target data is a target rivet height corresponding to the battery riveting process.

Optionally, the data prediction module is also configured for:
feature extraction of the monitoring data corresponding respectively to the plurality of batteries to obtain data characteristics corresponding to the monitoring data, the data characteristics including one or more of data distribution characteristics, data dispersion characteristics, and data temporal change characteristics; and
feature analysis and prediction of the data characteristics corresponding to the monitoring data based on a data prediction model to obtain prediction data corresponding to the next battery.

According to a third aspect of the present disclosure, an electronic device is provided, including:
a memory storing executable program code; and
a processor coupled with the memory;
wherein the processor executes the executable program code stored in the memory to perform the method described in the first aspect of the present disclosure.

According to a fourth aspect of the present disclosure, a computer-readable storage medium is provided, which stores a computer program, wherein the computer program, when executed by a processor, causes the processor to perform the method described in the first aspect of the present disclosure.

With method and apparatus for battery production control, the electronic device, and the storage medium provided in the present disclosure, the electronic device acquires monitoring data corresponding respectively to a plurality of batteries in the battery production process within a target time period, which monitoring data can reflect the condition of the battery after the completion of the battery production process. Based on the monitoring data, the electronic device can determine the prediction data corresponding to the next battery, that is, the electronic device can predict the future battery production status in the battery production process according to the monitoring data within a target time period, achieving prediction and planning of the battery production process. The electronic device then compares the prediction data with the threshold data corresponding to the battery production process to obtain a comparison result, and determines the battery production status corresponding to the battery production process based on the comparison result. By determining the prediction data corresponding to the next battery for the judgment of the battery production status corresponding to the battery production process, it is possible to accurately and promptly detect the battery production status, thereby improving the stability of battery production, and enhancing the qualification rate and production efficiency of the batteries.

### BRIEF DESCRIPTION OF THE DRAWINGS

To more clearly illustrate the technical solutions in the present disclosure, a brief introduction to the drawings required in the embodiments will be provided below. It is evident that the drawings described below are merely some embodiments of the present disclosure, and for those of ordinary skills in the art, without the need for creative effort, other drawings can also be obtained based on these drawings.
FIG. 1 is a schematic diagram of the application scenario of a method for battery production control provided by the present disclosure;
FIG. 2 is a flow diagram of a method for battery production control provided by the present disclosure;
FIG. 3 is a flow diagram of another method for battery production control provided by the present disclosure;
FIG. 4 is a modular diagram of an apparatus for battery production control provided by the present disclosure; and
FIG. 5 is a structural diagram of an electronic device provided by the present disclosure.

### DETAILED DESCRIPTION

In the following, technical solutions in the present disclosure will be described clearly and completely in conjunction with the drawings of the present disclosure. It is evident that the described embodiments are only some of the embodiments of the present disclosure, rather than all the embodiments. All other embodiments obtained by those of ordinary skills in the art without making creative efforts, based on the embodiments in this disclosure, fall within the scope of protection of the present disclosure.

It should be noted that the terms "include" and "have" and any of their variations in the present disclosure are intended to cover non-exclusive inclusion, such as a process, method, system, product, or device that includes a series of steps or units, which does not have to be limited to those clearly listed steps or units, but may include other steps or units that are not clearly listed or inherent to these processes, methods, products, or devices.

It is understood that the terms "first," "second," and so on used in this disclosure are employed to describe various elements and are not limited by these terms. These terms are used solely to distinguish one element from another. For example, without departing from the scope of the present disclosure, the first element may be referred to as the second element, and similarly, the second element may be referred to as the first element. Both the first and second elements are elements, but they are not the same element.

In the relevant technologies, the electrolyte injection process is a link in the lithium battery production line, which can be the process of injecting the electrolyte that serves as the discharge medium between the positive and negative electrodes of the battery into the battery cell. Whether the electrolyte can fully saturate the battery cell will directly influence the performance and safety of the lithium battery. As one of the important processes in the production of lithium batteries, the electrolyte injection process also poses direct influence on the overall efficiency of production.

The amount of electrolyte injected is a key factor influencing the saturation effect of the electrolyte on the battery cell. It is qualified if the electrolyte injection amount of a single battery cell reaches a pre-set range. As production progresses, the electrolyte injection port, pump, and station included in the battery injection position may gradually develop abnormities due to reasons such as electrolyte crystallization and spillage, leading to problems such as blockage of the injection port, thereby causing abnormities in the battery production status. At present, most on-site production personnel of lithium battery manufacturers do not have clear definition standards for abnormities in battery production status and occasional abnormities in injection amount. They judge based on personal experience, which leads to a certain degree of misjudgment and missed judgment. This results in the battery production process not being maintained in time, reducing the stability of battery production, and leading to a large number of unqualified products, thereby reducing product qualification rate and production efficiency.

In addition, after the electrolyte injection is completed, the battery riveting position can press the rubber rivet into the electrolyte injection port of the battery for sealing the battery. The rubber rivet must be flush with the injection port, that is, the height of the rubber rivet is 0. The height of the rubber rivet can be the height difference between the rubber rivet and the injection port. If there is a deviation in the height of the rubber rivet, it will influence the welding effect of the subsequent sealing process. At present, most on-site production personnel of lithium battery manufacturers adjust the rivet height by adjusting the rivet pressure value of the riveting device. If there is an abnormity in the height of the rubber rivet, they can only rely on personal experience and adjust the riveting device to the appropriate rivet pressure value through continuous trial and error. This adjustment process seriously influences production efficiency and produces a large number of unqualified products, reducing the stability of battery production.

The present disclosure provides method and an apparatus for battery production control, an electronic device, and a storage medium, which can accurately and timely detect the battery production status, thereby improving the stability of battery production and enhancing the qualification rate and production efficiency of the batteries.

A detailed description will be given in conjunction with the drawings below.

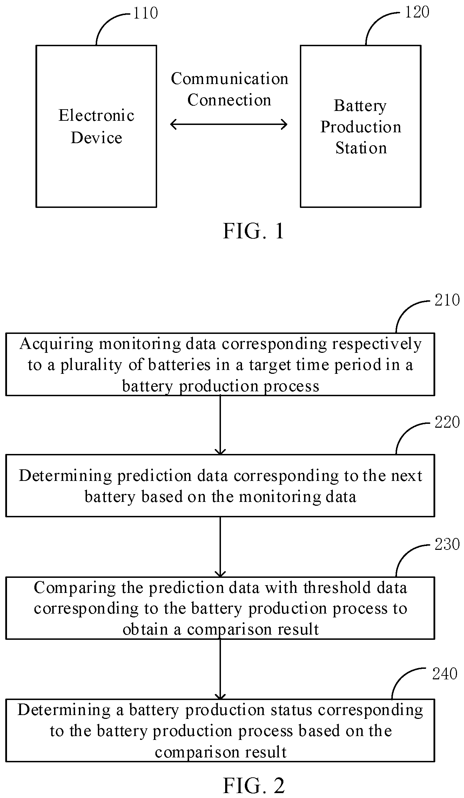

As shown in FIG. 1, FIG. 1 is a schematic diagram of the application scenario of a method for battery production control provided by an embodiment of the present disclosure. This application scenario may include an electronic device 110 and a battery production station 120. The electronic device 110 may include, but is not limited to, mobile phones, tablet computers, wearable devices, laptop computers, PCs (Personal Computers), etc. In addition, the operating system of the electronic device 110 may include, but is not limited to, the Android operating system, IOS operating system, Symbian operating system, Black Berry operating system, Windows Phone 8 operating system, etc., and is not limited in the present disclosure. The battery production station 120 may include, but is not limited to, a battery electrolyte injection station, a battery riveting station, etc. The battery electrolyte injection station can be used for the electrolyte injection process of the battery, which can refer to the process of injecting the electrolyte into the interior of the battery through the injection port. The battery riveting process can refer to the process of pressing the rubber rivet into the injection port of the battery, which can seal the battery with the rubber rivet. The electronic device can establish a communication connection with the battery production station 120, which can send the monitoring data corresponding to the battery in the battery production process to the electronic device 110. This communication connection may include a wired connection or a wireless connection, and is not limited to this. The battery production station 120 may include one or more, and only one is illustrated in FIG. 1, which does not mean that the electronic device 110 can only communicate with one battery production station 120.

In the process, the electronic device 110 can acquire monitoring data corresponding respectively to a plurality of batteries during a target time period in the battery production process, which battery production process includes at least one type, such as the battery electrolyte injection process, the battery riveting process, etc. This monitoring data is used for reflecting the condition of the battery after the battery production process is completed. Based on the monitoring data, the electronic device 110 can determine the prediction data corresponding to the next battery, then compare the prediction data with the threshold data corresponding to the battery production process to obtain a comparison result, and thus determine the battery production status corresponding to the battery production process based on the comparison result.

Optionally, when the battery production process is the battery electrolyte injection process, the monitoring data can be the amount of electrolyte injected. The electronic device 110 can acquire the amount of electrolyte injected corresponding to a plurality of batteries during the target time period in the battery electrolyte injection process. This amount of electrolyte injected can be used for reflecting the electrolyte injection amount after the battery completes the electrolyte injection process. Based on this amount of electrolyte injected, the electronic device 110 can determine the prediction data corresponding to the next battery, which can predict the electrolyte injection amount after the next battery undergoes the electrolyte injection process. The electronic device 110 then compares the prediction data with the threshold data corresponding to the electrolyte injection process to obtain a comparison result, and thus determines the battery production status corresponding to the electrolyte injection process based on the comparison result.

Optionally, when the battery production process is the battery riveting process, the monitoring data can be the height of the rubber rivet, which can be the height of the rubber rivet relative to the injection port. The deeper the rubber rivet is inserted into the injection port of the battery, the smaller the height of the rubber rivet. The electronic device 110 can acquire the height of the rubber rivet corresponding to a plurality of batteries during the target time period in the battery riveting process. This height of the rubber rivet can be used for reflecting the height of the rubber rivet relative to the injection port after the battery completes the riveting process. Based on this height of the rubber rivet, the electronic device 110 can determine the prediction data corresponding to the next battery, which can predict the height of the rubber rivet after the next battery undergoes the riveting process. The electronic device 110 then compares the prediction data with the threshold data corresponding to the riveting process to obtain a comparison result, and thus determines the battery production status corresponding to the riveting process based on the comparison result.

As shown in FIG. 2, FIG. 2 is a flow diagram of a method for battery production control provided by the present disclosure. This method for battery production control can be applied to the electronic devices in the aforementioned examples and may include:

Step 210, acquiring monitoring data corresponding respectively to a plurality of batteries in the battery production process during a target time period.

During the target time period, the battery production station can carry out the battery production process for a plurality of batteries, which battery production process includes at least one type. Optionally, the battery production process may include an electrolyte injection process for the batteries and a riveting process for the batteries. In the case that the battery production process is the electrolyte injection process, the electrolyte injection station can carry out the electrolyte injection process for a plurality of batteries. In the case that the battery production process is the riveting process, the riveting station can carry out the riveting process for a plurality of batteries.

The electronic device can acquire monitoring data corresponding respectively to a plurality of batteries in the battery production process during the target time period. This monitoring data can be used for reflecting the condition of the batteries after completing the battery production process, and the target time period can be the time period when the battery production station most recently carried out the battery production process for a plurality of batteries.

Here, the monitoring data can be data obtained by monitoring the battery after it has completed the battery production process. After the battery production station completes the battery production process for the target battery during the target time period, the monitoring data corresponding to this target battery can be obtained. The target battery can be any one of a plurality of batteries. In the electrolyte injection process, the monitoring data may include the amount of electrolyte injected into the battery after the electrolyte injection process is completed at the electrolyte injection station. In the riveting process, the monitoring data may include the height of the rubber rivet after the riveting process is completed at the riveting station, where the riveting station may include a riveting device that applies pressure to the rubber rivet to press it into the injection port of the battery. The method by which the electronic device acquires this monitoring data is not limited; optionally, after the electrolyte injection process is completed, the weight of the battery can be measured by a weight sensor to determine the amount of electrolyte injected. After the riveting process is completed, the height of the rubber rivet can be determined by obtaining an image of the rivet through an image sensor.

Step 220, determining prediction data corresponding to the next battery based on the monitoring data.

Here, the electronic device determines the prediction data for the next battery based on the monitoring data, which can predict the monitoring data after the next battery completes the battery production process, that is, the monitoring data obtained by the battery production station after completing the production process for the next battery may be the same as the prediction data.

Optionally, the electronic device can analyze and model the historical data corresponding to the battery production process to construct a data prediction model. This data prediction model can determine the prediction data for the next battery based on the monitoring data. The historical data is used for reflecting the situation of the battery production station performing the battery production process on the batteries in the past time period, and the amount of historical data is much larger than the amount of monitoring data. The data prediction model can include statistical models, machine learning models, or deep learning models. The electronic device can preprocess and annotate the historical data, and then train the data prediction model with the historical data. During the training process, the data prediction model can learn the trends and correlations in the historical data, so that after training, it can determine the prediction data for the next battery.

In one embodiment, the electronic device can extract features from the monitoring data corresponding to a plurality of batteries to obtain data characteristics corresponding to the monitoring data. Based on the data prediction model, it analyzes and predicts the features of the monitoring data to obtain the prediction data for the next battery.

The data characteristics can include one or more of data distribution characteristics, data dispersion characteristics, and data temporal change characteristics. The data distribution characteristics can include but are not limited to the central tendency (such as mean, median), dispersion (such as variance, standard deviation), and skewness (such as skewness, kurtosis) of the monitoring data corresponding to a plurality of batteries. The data dispersion characteristics can be used for representing the range of variation and abnormities of the monitoring data corresponding to a plurality of batteries. The data temporal change characteristics can be used for analyzing the temporal changes in the monitoring data corresponding respectively to a plurality of batteries, extracting features such as trends, periodicity, seasonality, and autocorrelation of the monitoring data to determine the temporal evolution rules of the monitoring data.

By implementing this embodiment, the prediction data can be applied to abnormity detection and troubleshooting, as well as further optimization, thereby improving the production efficiency of the battery production process and the product quality of the batteries. Through continuous data acquisition, analysis, and optimization, the accuracy and reliability of the prediction data can be continuously improved, providing support for the status monitoring and control of the battery production process.

Step 230, comparing prediction data with threshold data corresponding to the battery production process to obtain a comparison result.

Here, the threshold data can be used to describe the conditions of the battery after it has completed the battery production process under various battery production statuses. Optionally, the threshold data can be obtained through statistical analysis of the monitoring data after the battery has completed the battery production process under various battery production statuses. In the battery electrolyte injection process, the threshold data can include the amount of electrolyte injected after the battery has completed the electrolyte injection process under normal status, the amount of electrolyte injected after the battery has completed the electrolyte injection process under corrected status, and the amount of electrolyte injected after the battery has completed the electrolyte injection process under abnormal status. In the battery riveting process, the threshold data can include the height of the rubber rivet after the battery has completed the riveting process under normal status, the height of the rubber rivet after the battery has completed the riveting process under corrected status, and the height of the rubber rivet after the battery has completed the riveting process under abnormal status.

Optionally, the abnormal status is a status where the battery production status cannot return to normal after the production parameters corresponding to the battery production process are adjusted. The corrected status is a status where the battery production status returns to normal after the production parameters corresponding to the battery production process are adjusted. Here, the production parameters corresponding to different battery production processes can be different, such as the production parameters corresponding to the battery electrolyte injection process being different from those corresponding to the battery riveting process.

The threshold data can be used to represent the threshold ranges corresponding to various battery production statuses. Optionally, the threshold data can be used to represent the first threshold range corresponding to the normal status and the second threshold range corresponding to the corrected status. The threshold data can include the range threshold for the first threshold range and the range threshold for the second threshold range. The range threshold for the first threshold range can include the upper boundary of the first threshold range and the lower boundary of the first threshold range. The range threshold for the second threshold range can include the upper boundary of the second threshold range and the lower boundary of the second threshold range. Here, the second threshold range can include the first threshold range, meaning that the range of the second threshold range is larger than the range of the first threshold range. Any data within the first threshold range is also within the second threshold range. The upper boundary corresponding to the second threshold range is greater than the upper boundary of the first threshold range, and the lower boundary corresponding to the second threshold range is less than the lower boundary of the first threshold range.

The electronic device compares the prediction data with the threshold data corresponding to the battery production process to determine the range in which the prediction data falls. That is, the comparison result can be used to represent the range where the prediction data is located.

Step 240, determining a battery production status corresponding to the battery production process based on the comparison result.

The electronic device can determine the range in which the prediction data falls based on the comparison result, and based on this range, it can determine the battery production status corresponding to the battery production process. Each battery production status can correspond to a range, and when the threshold data includes the range threshold for the first threshold range and the range threshold for the second threshold range, that is, when the threshold data is used to represent the first threshold range corresponding to the normal status and the second threshold range corresponding to the corrected status, the threshold range corresponding to the abnormal status can be any range other than the second threshold range.

In one embodiment, the electronic device can determine the prediction data corresponding to a plurality of batteries in a future time period based on the monitoring data, compare the prediction data for each battery with the threshold data corresponding to the battery production process, obtain the comparison results for each battery, and determine the battery production status corresponding to the battery production process based on the comparison results for a plurality of batteries corresponding respectively. Optionally, a plurality of batteries in the future time period can correspond to weights respectively, and the weight corresponding to the battery that is produced closer to the current time is greater, for example, the weight corresponding to the next battery can be greater than the weight corresponding to the next but one battery. The electronic device can determine the battery production status corresponding to the battery production process based on the comparison results for a plurality of batteries corresponding respectively and the weights. Implementing this embodiment, by predicting the prediction data for a plurality of batteries in the future time period to determine the battery production status corresponding to the battery production process, the accuracy of determining the battery production status can be improved.

In the present disclosure, the electronic device acquires the monitoring data corresponding to a plurality of batteries in the battery production process during the target time period, which can reflect the condition of the battery after completing the battery production process. Based on the monitoring data, the electronic device can determine the prediction data for the next battery, that is, the electronic device can predict the future battery production status in the battery production process according to the monitoring data in the target time period, achieving prediction and planning of the battery production process. The electronic device then compares the prediction data with the threshold data corresponding to the battery production process to obtain the comparison result, and determines the battery production status corresponding to the battery production process based on the comparison result. By determining the prediction data corresponding to the next battery for the judgment of the battery production status corresponding to the battery production process, it is possible to accurately and promptly detect the battery production status, thereby improving the stability of battery production, and enhancing the qualification rate and production efficiency of the batteries.

After determining the battery production status corresponding to the battery production process, the electronic device can also perform corresponding processing methods based on the battery production status. For example, the processing method corresponding to the abnormal status can be to output abnormity warning information, and the processing method corresponding to the corrected status can be to adjust production parameters.

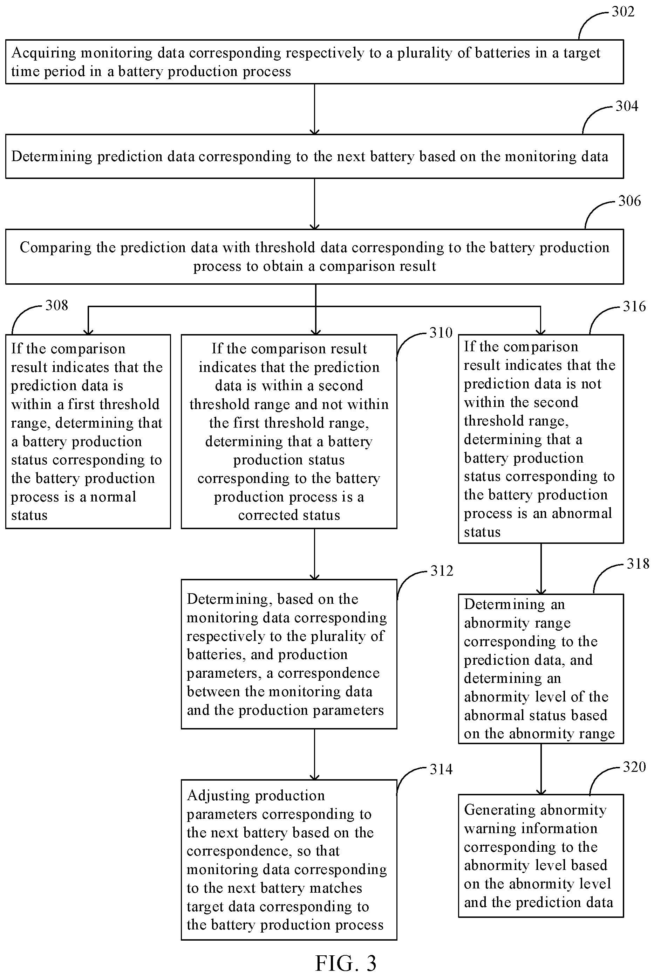

As shown in FIG. 3, which is a flow diagram of another method for battery production control provided by the present disclosure. This method for battery production control can be applied to the electronic devices in the aforementioned examples. This method for battery production control may include:

Step 302, acquiring monitoring data corresponding respectively to a plurality of batteries in a target time period in a battery production process.

Step 304, determining prediction data corresponding to the next battery based on the monitoring data.

Step 306, comparing the prediction data with threshold data corresponding to the battery production process to obtain a comparison result.

The methods of Steps 302 to 306 are the same as the methods of Steps 210 to 230 in the aforementioned embodiments and will not be further elaborated here. The electronic device can determine to perform one of the steps in Steps 308, 310, and 316 based on the comparison result.

Step 308, if the comparison result indicates that the prediction data is within a first threshold range, determining that the battery production status corresponding to the battery production process is a normal status.

When the comparison result indicates that the prediction data is within the first threshold range, for example, in the battery electrolyte injection process, the first threshold range is 95g (gram) to 105g, with the prediction data being 99g, the electronic device can determine that the battery production status corresponding to the battery production process is in a normal status. Batteries produced under the normal status in the battery production process meet the requirements, and no adjustments are needed for the battery production process.

Step 310, if the comparison result indicates that the prediction data is within the second threshold range and not within the first threshold range, determining that the battery production status corresponding to the battery production process is in a corrected status.

When the comparison result indicates that the prediction data is within the second threshold range and not within the first threshold range, for example, in the battery electrolyte injection process, the first threshold range is 95g to 105g, and the second threshold range is 90g to 110g, with the prediction data being 91g, the electronic device can determine that the battery production status corresponding to the battery production process is in a corrected status. Batteries produced under the corrected status in the battery production process do not meet the requirements, but adjustments to the production parameters corresponding to the battery production process can be made to ensure that the batteries meet the requirements after completing the battery production process.

Step 312, determining, based on the monitoring data corresponding respectively to the plurality of batteries, and production parameters, a correspondence between the monitoring data and the production parameters.

If the battery production status is in a corrected status, it indicates that after adjusting the workstation parameters corresponding to the battery production process, the battery production status can return to a normal status. The electronic device can determine the correspondence between the monitoring data and the production parameters based on the monitoring data and production parameters corresponding respectively to a plurality of batteries. This correspondence is used for representing the pattern of change in the monitoring data when the production parameters change.

When the battery production process is the electrolyte injection process, the production parameter corresponding to the battery production process can be the pre-set electrolyte injection amount for the electrolyte injection process. This pre-set electrolyte injection amount can be the pre-set monitoring data after completing the electrolyte injection process for the battery. It should be understood that since the battery production status corresponding to the electrolyte injection process is in a corrected status, that is, the batteries produced by the battery production process do not meet the requirements, the electrolyte injection station cannot guarantee that the electrolyte injection amount after completing the electrolyte injection process for the battery is exactly the same as the pre-set injection amount. The electronic device can determine the correspondence between the pre-set injection amount and the actual electrolyte injection amount, for example, when the pre-set injection amount is 100g: since the battery production status corresponding to the electrolyte injection process is the corrected status, the actual electrolyte injection amount after completing the electrolyte injection process for the battery can be only 91g.

When the battery production process is the riveting process, the production parameter corresponding to the battery production process can be the riveting pressure value for the riveting process. This riveting pressure value can be the pressure value when the riveting device performs the riveting process on the battery. The electronic device can determine the correspondence between the riveting pressure value and the height of the rubber rivet, for example, when the riveting pressure value is 10 Newtons, the height of the rubber rivet after completing the riveting process for the battery under normal status can be 0, that is, the rubber rivet is completely flush with the injection port. Under the corrected status, the height of the rubber rivet after completing the riveting process for the battery can be 2 centimeters, that is, the rubber rivet is 2 centimeters higher than the injection port.

Step 314, adjusting production parameters corresponding to the next battery based on the correspondence, so that monitoring data corresponding to the next battery matches target data corresponding to the battery production process.

Here, the target data is the data that needs to be achieved after the battery has completed the battery production process. In the case of the battery production process being the electrolyte injection process, the production parameter is the pre-set electrolyte injection amount corresponding to the electrolyte injection process, and the target data is the target electrolyte injection amount corresponding to the electrolyte injection process; in the case of the battery production process being the riveting process, the production parameter is the riveting pressure value corresponding to the riveting process, and the target data is the target rubber rivet height corresponding to the riveting process.

In order to match the monitoring data corresponding to the next battery with the target data corresponding to the battery production process, that is, to ensure that the batteries obtained from the battery production process are qualified, the electronic device can adjust the production parameters corresponding to the next battery based on the correspondence between the monitoring data and the production parameters. For example, when the battery production process is the electrolyte injection process, the target electrolyte injection amount corresponding to the qualified battery is 100g. Based on the correspondence between the pre-set injection amount and the monitoring data, to ensure that the electrolyte injection amount of the next battery reaches 100g after completing the electrolyte injection process, the pre-set electrolyte injection amount corresponding to the next battery can be determined to be 110g.

Step 316, if the comparison result indicates that the prediction data is not within the second threshold range, determining that a battery production status corresponding to the battery production process is an abnormal status.

When the comparison result indicates that the prediction data is not within the second threshold range, for example, in the electrolyte injection process, the first threshold range is 95g to 105g, and the second threshold range is 90g to 110g, with the prediction data being 80g, the electronic device can determine that the battery production status corresponding to the battery production process is in an abnormal status. Batteries produced under the abnormal status in the battery production process do not meet the requirements, and due to the large difference between the prediction data and the target data, even after adjusting the production parameters corresponding to the battery production process, the batteries completed in the battery production process cannot meet the requirements. The electronic device can output abnormity warning information to alert the staff to take action.

Step 318, determining an abnormity range corresponding to the prediction data, and determining an abnormity level of the abnormal status based on the abnormity range.

Here, the abnormity range can include multiple ones, each abnormity level corresponding to an abnormity range, such as the abnormity level which can include general abnormities and serious abnormities, the abnormity range corresponding to each abnormity level is pre-set, and can be divided according to the abnormal data in the historical data. When the battery production status is in an abnormal status, the electronic device can determine the abnormity range corresponding to the prediction data, and determine the abnormity level corresponding to this abnormity range as the abnormity level of the abnormal status.

As an optional implementation method, the electronic device can also determine the abnormity level of the abnormal status based on the prediction data and the target data. The electronic device can calculate the difference between the prediction data and the target data, and determine the abnormity level of the abnormal status based on the magnitude of this difference.

Step 320, generating abnormity warning information corresponding to the abnormity level based on the abnormity level and the prediction data

The electronic device, based on the abnormity level of the abnormal status and the prediction data corresponding to the next battery, can generate abnormity warning information corresponding to the abnormity level, which can be used to alert staff to handle abnormal situations. Optionally, the abnormity warning information can include but is not limited to abnormal workstations, workstation status, abnormity levels, monitoring data, and prediction data, etc. If a normal equipment instruction is received from the staff, the battery production status is determined to be a normal status; and if an abnormal equipment instruction is received from the staff, the battery production status is further determined to be an abnormal status, the battery production process can be stopped, and corresponding maintenance operations can be performed on the battery production workstation, the present disclosure will not make further elaboration on this.

In one embodiment, the electronic device can obtain the monitoring data corresponding to multiple batteries in the battery production process during a historical time period, and statistically analyze the change in the abnormal rate of the battery production status and the frequency of various abnormal issues through statistical methods. Here, statistical methods can include but are not limited to central tendency analysis, normality testing, cluster analysis, etc. Implementing this embodiment can quantify the analysis of the battery production process and improve the efficiency of determining the abnormal status.

In the present disclosure, the electronic device can also determine the range where the comparison result falls to determine the battery production status corresponding to the battery production process, thereby improving the accuracy of determining the battery production status. When the battery production status is in the corrected status, the electronic device can determine the correspondence between the monitoring data and the production parameters based on the monitoring data corresponding to multiple batteries and the production parameters. The electronic device can adjust the production parameters corresponding to the next battery based on the correspondence between the monitoring data and the production parameters, so as to match the monitoring data corresponding to the next battery with the target data corresponding to the battery production process, improving the yield of battery production. When the battery production status is in an abnormal status, the electronic device can determine the abnormity range corresponding to the prediction data, and based on the abnormity range, determine the abnormity level of the abnormal status, and then generate abnormity warning information corresponding to the abnormity level based on the abnormity level and the prediction data, to alert staff to handle the abnormal situation of the battery production status, to avoid producing more unqualified batteries when the battery production status is in an abnormal status, thereby improving the yield of battery production, avoiding losses caused by unqualified products, and improving the stability of the battery production process.

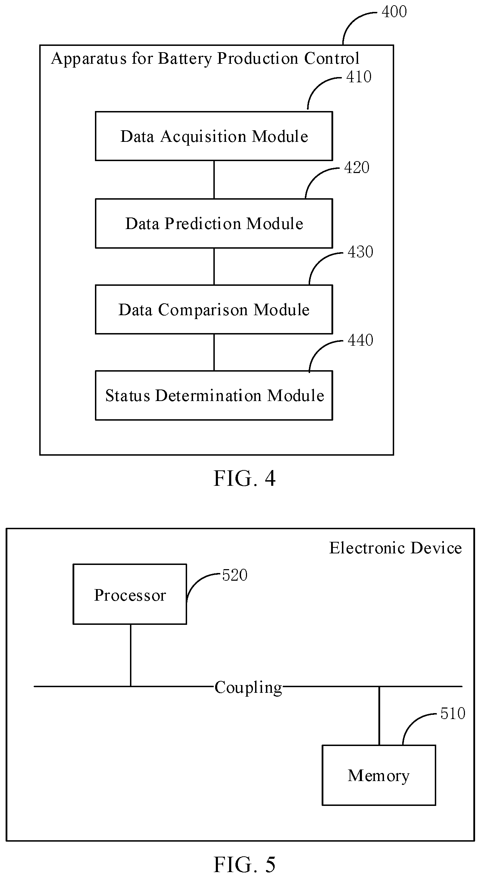

As shown in Figure 4, Figure 4 is a modular schematic diagram of an apparatus for battery production control provided by the present disclosure, which can include a data acquisition module 410, a data prediction module 420, a data comparison module 430, and a status determination module 440, where:
Data acquisition module 410, used for acquiring monitoring data corresponding respectively to a plurality of batteries in a target time period in a battery production process, wherein the battery production process comprises at least one type, and the monitoring data is used for reflecting condition of the battery after completion of the battery production process;
Data prediction module 420, used for determining prediction data corresponding to the next battery based on the monitoring data corresponding respectively to the plurality of batteries;
Data comparison module 430, used for comparing the prediction data with threshold data corresponding to the battery production process to obtain a comparison result.

Status determination module 440, used for determining the battery production status corresponding to the battery production process based on the comparison result.

Here, when the battery production process is a battery electrolyte injection process, the monitoring data is an amount of battery electrolyte injection, and when the battery production process is a battery riveting process, the monitoring data is a height of a rivet, the battery riveting process referring to a process of pressing the rivet into the electrolyte injection port of the battery.

In one embodiment, the battery production status includes a normal status, an abnormal status, and a corrected status. The abnormal status is a status where the battery production status cannot return to the normal status after the production parameters corresponding to the battery production process are adjusted. The corrected status is a status where the battery production status returns to the normal status after the production parameters corresponding to the battery production process are adjusted.

In one embodiment, the threshold data includes a first threshold range corresponding to the normal status and a second threshold range corresponding to the corrected status, with the second threshold range including the first threshold range. The status determination module 440 is also used for determining that if the comparison result indicates the prediction data is within the first threshold range, the battery production status corresponding to the battery production process is a normal status. If the comparison result indicates the prediction data is within the second threshold range and not within the first threshold range, then it is determined that the battery production status corresponding to the battery production process is a corrected status. If the comparison result indicates the prediction data is not within the second threshold range, then it is determined that the battery production status corresponding to the battery production process is an abnormal status.

In one embodiment, the battery production control apparatus may further include an exception handling module, which is configured for: determining the abnormity range corresponding to the prediction data when the battery production status corresponding to the battery production process is the abnormal status, determining the abnormity level of the abnormal status based on the abnormity range, and generating abnormity warning information corresponding to the abnormity level based on the abnormity level and the prediction data.

In one embodiment, the battery production control apparatus may also include a parameter correction module, which is used for: when the battery production status corresponding to the battery production process is the corrected status, determining a correspondence between the monitoring data and the production parameters, based on the monitoring data and production parameters corresponding to multiple batteries; and adjusting the production parameters corresponding to the next battery based on the correspondence, so that the monitoring data corresponding to the next battery matches the target data corresponding to the battery production process.

In one embodiment, when the battery production process is the battery electrolyte injection process, the production parameter is a pre-set electrolyte injection amount corresponding to the battery electrolyte injection process, and the target data is a target electrolyte injection amount corresponding to the battery electrolyte injection process; and when the battery production process is the battery riveting process, the production parameter is a riveting pressure value corresponding to the battery riveting process, and the target data is a target rivet height corresponding to the battery riveting process.

In one embodiment, the data prediction module 420 is also used for: feature extraction of the monitoring data corresponding respectively to the plurality of batteries to obtain data characteristics corresponding to the monitoring data, the data characteristics including one or more of data distribution characteristics, data dispersion characteristics, and data temporal change characteristics; and feature analysis and prediction of the data characteristics corresponding to the monitoring data based on a data prediction model to obtain prediction data corresponding to the next battery.

In the present disclosure, the electronic device acquires the monitoring data corresponding to multiple batteries in the battery production process during the target time period, which can reflect the condition of the battery after completing the battery production process. Based on the monitoring data, the electronic device can determine the prediction data corresponding to the next battery, that is, the electronic device can predict the future battery production status in the battery production process according to the monitoring data in the target time period, achieving prediction and planning of the battery production process. The electronic device then compares the prediction data with the threshold data corresponding to the battery production process to obtain a comparison result, and determines the battery production status corresponding to the battery production process based on the comparison result. By determining the prediction data corresponding to the next battery, the method can accurately and timely detect the battery production status, thereby improving the stability of battery production and enhancing the qualification rate and production efficiency of the batteries.

As shown in Figure 5, in one embodiment, an electronic device is provided, which may include:
a memory 510 storing executable program code; and
a processor 520 coupled with the memory 510;
wherein he processor 520 calls the executable program code stored in the memory 510 to perform the battery production control methods provided in the aforementioned embodiments.

The memory 510 may include Random Access Memory (RAM) and may also include Read-Only Memory (ROM). The memory 510 is used for storing instructions, programs, codes, code sets, or instruction sets. The memory 510 may include a storage program area and a storage data area, where the storage program area can store instructions for implementing an operating system, instructions for implementing at least one function (such as touch control, sound playback, image playback, etc.), and instructions for implementing the methods described in the embodiments above. The storage data area can also store data created by the electronic device during use.

The processor 520 may include one or more processing cores. The processor 520 uses various interfaces and lines to connect all parts within the electronic device, and by running or executing the instructions, programs, code sets, or instruction sets stored in the memory 510, as well as calling the data stored in the memory 510, it performs various functions of the electronic device and processes data. Optionally, the processor 520 can be implemented using at least one hardware form of Digital Signal Processing (DSP), Field-Programmable Gate Array (FPGA), and Programmable Logic Array (PLA). The processor 520 can integrate a combination of one or several of a Central Processing Unit (CPU), a Graphics Processing Unit (GPU), and a modem. Among them, the CPU mainly processes the operating system, user interface, and application software; the GPU is responsible for rendering and drawing display content; the modem is used for processing wireless communication. It should be understood that the aforementioned modem can also not be integrated into the processor 520 and can be implemented separately through a communication chip.

It can be understood that the electronic device may include more or fewer structural components than the above structural frame diagram, such as a power supply module, physical buttons, WiFi (Wireless Fidelity, wireless fidelity) module, speaker, Bluetooth module, sensor, etc., and is not limited here.

The present disclosure provides a computer-readable storage medium that stores a computer program, which enables the computer to execute the methods described in the aforementioned embodiments.

In addition, the present disclosure further provides a computer program product, which, when the computer program product is run on a computer, enables the computer to execute all or part of the steps of any of the battery production control methods described in the embodiments above.

Those of ordinary skills in the art can understand that all or part of the steps in the various methods of the foregoing examples can be accomplished by instructing relevant hardware with a program, which can be stored on a computer-readable storage medium. The storage medium includes Read-Only Memory (ROM), Random Access Memory (RAM), Programmable Read-only Memory (PROM), Erasable Programmable Read Only Memory (EPROM), One-time Programmable Read-Only Memory (OTPROM), Electrically-Erasable Programmable Read-Only Memory (EEPROM), Compact Disc Read-Only Memory (CD-ROM) or other optical disc storage, disk storage, tape storage, or any other medium readable by a computer that is capable of carrying or storing data.

The detailed introduction of the method and apparatus for battery production control, the electronic device, and the storage medium provided in the present disclosure has been described above. Specific examples have been applied in this text to elucidate the principles and implementation methods of the present disclosure. The descriptions of the foregoing examples are merely for the purpose of aiding in the understanding of the method and its core ideas as disclosed. At the same time, for those of ordinary skills in the art, there will be changes in the specific implementation methods and application scope based on the ideas of the present disclosure. In summary, the content of this disclosure should not be construed as a limitation on the present disclosure.

## Claims

1. A method for battery production control, **characterized by** comprising:
acquiring monitoring data corresponding respectively to a plurality of batteries in a target time period in a battery production process, wherein the battery production process comprises at least one type, and the monitoring data is used for reflecting condition of the battery after completion of the battery production process;
determining prediction data corresponding to the next battery, based on the monitoring data corresponding respectively to the plurality of batteries;
comparing the prediction data with threshold data corresponding to the battery production process to obtain a comparison result;
determining the battery production status corresponding to the battery production process based on the comparison result;
wherein, when the battery production process is a battery electrolyte injection process, the monitoring data is an amount of battery electrolyte injection, and when the battery production process is a battery riveting process, the monitoring data is a height of a rivet, the battery riveting process referring to a process of pressing the rivet into an electrolyte injection port of the battery.

2. The method of claim 1, **characterized in that** the battery production status comprises a normal status, an abnormal status, and a corrected status,
the abnormal status being a status where the battery production status cannot return to the normal status after the production parameters corresponding to the battery production process are adjusted, and
the corrected status being a status where the battery production status returns to the normal status after the production parameters corresponding to the battery production process are adjusted.

3. The method of claim 2, **characterized in that** the threshold data comprises a first threshold range corresponding to the normal status and a second threshold range corresponding to the corrected status, the second threshold range including the first threshold range, and determining the battery production status corresponding to the battery production process based on the comparison result comprises:
if the comparison result indicates that the prediction data is within the first threshold range, determining that the battery production status corresponding to the battery production process is the normal status;
if the comparison result indicates that the prediction data is within the second threshold range and not within the first threshold range, determining that the battery production status corresponding to the battery production process is the corrected status; and
if the comparison result indicates that the prediction data is not within the second threshold range, determining that the battery production status corresponding to the battery production process is the abnormal status.

4. The method of claim 2, **characterized in that** after determining the battery production status corresponding to the battery production process based on the comparison result, the method further comprises:
if the battery production status corresponding to the battery production process is the abnormal status, determining an abnormity range corresponding to the prediction data, and determining an abnormity level of the abnormal status based on the abnormity range; and
generating abnormity warning information corresponding to the abnormity level based on the abnormity level and the prediction data.

5. The method of claim 2, **characterized in that** after determining the battery production status corresponding to the battery production process based on the comparison result, the method further comprises:
if the battery production status corresponding to the battery production process is the corrected status, determining a correspondence between the monitoring data and the production parameters based on the monitoring data corresponding respectively to the plurality of batteries and the production parameters; and
adjusting the production parameters corresponding to the next battery based on the correspondence, so that monitoring data corresponding to the next battery matches the target data corresponding to the battery production process.

6. The method of claim 5, **characterized in that**:
when the battery production process is the battery electrolyte injection process, the production parameter is a pre-set electrolyte injection amount corresponding to the battery electrolyte injection process, and the target data is a target electrolyte injection amount corresponding to the battery electrolyte injection process; and
when the battery production process is the battery riveting process, the production parameter is a riveting pressure value corresponding to the battery riveting process, and the target data is a target rivet height corresponding to the battery riveting process.

7. The method of claim 1, **characterized in that** determining the prediction data corresponding to the next battery based on the monitoring data corresponding respectively to the plurality of batteries comprises:
feature extraction of the monitoring data corresponding respectively to the plurality of batteries to obtain data characteristics corresponding to the monitoring data, the data characteristics comprising one or more of data distribution characteristics, data dispersion characteristics, and data temporal change characteristics; and
feature analysis and prediction of the data characteristics corresponding to the monitoring data based on a data prediction model to obtain prediction data corresponding to the next battery.

8. An apparatus for battery production control, **characterized by** comprising:
a data acquisition module for acquiring monitoring data corresponding respectively to a plurality of batteries in a target time period in a battery production process, wherein the battery production process comprises at least one type, and the monitoring data is used for reflecting condition of the battery after completion of the battery production process;
a data prediction module for determining prediction data corresponding to the next battery based on the monitoring data corresponding respectively to the plurality of batteries;
a data comparison module for comparing the prediction data with threshold data corresponding to the battery production process to obtain a comparison result; and
a status determination module for determining the battery production status corresponding to the battery production process based on the comparison result;
wherein, when the battery production process is a battery electrolyte injection process, the monitoring data is an amount of battery electrolyte injection, and when the battery production process is a battery riveting process, the monitoring data is a height of a rivet, the battery riveting process referring to a process of pressing the rivet into the electrolyte injection port of the battery.

9. An electronic device, **characterized by** comprising:
a memory storing executable program code; and
a processor coupled with the memory;
wherein the processor executes the executable program code stored in the memory to perform the method of any one of claims 1 to 7.

10. A computer-readable storage medium, **characterized in that** the computer-readable storage medium stores a computer program, wherein the computer program, when executed by a processor, causes the processor to perform the method of any one of claims 1 to 7.
